# EUROPÄISCHE PATENTSCHRIFT

(11) **EP 1 356 527 B1**
(45) Veröffentlichungstag und Bekanntmachung des Hinweises auf die Patenterteilung: **03.02.2010**
(21) Anmeldenummer: 02714145.6
(22) Anmeldetag: 04.02.2002
(51) Int. Cl.: H01L 29/737, H01L 21/331

(54) **BIPOLARTRANSISTOR UND VERFAHREN ZU DESSEN HERSTELLUNG**
BIPOLAR TRANSISTOR AND METHOD FOR PRODUCING THE SAME
TRANSISTOR BIPOLAIRE ET SON PROCEDE DE FABRICATION

(30) Priorität: 02.02.2001 DE 10104776
(43) Veröffentlichungstag der Anmeldung: 29.10.2003
(73) Patentinhaber: Infineon Technologies AG, 81669 München (DE)
(72) Erfinder: FRANOSCH, Martin, 81739 München (DE); MEISTER, Thomas, 82024 Taufkirchen (DE); SCHAEFER, Herbert, 85635 Höhenkirchen-Siegertsbrunn (DE); STENGL, Reinhard, 86391 Stadtbergen (DE)
(74) Vertreter: Ginzel, Christian
(86) Internationale Anmeldenummer: PCT/EP2002/001125
(87) Internationale Veröffentlichungsnummer: WO 2002/061843

(56) Entgegenhaltungen:
- US-A- 5 424 227
- US-A- 5 587 327
- SCHREIBER ET AL.: "SI/SIGE HETEROJUNCTION BIPOLAR TRANSISTOR WITH BASE DOPING HIGHLY EXCEEDING EMITTER DOPING CONCENTRATION" ELECTRONICS LETTERS, IEE STEVENAGE, GB, Bd. 25, Nr. 3, 2. Februar 1989 (1989-02-02), Seiten 185-186, XP000047756 ISSN: 0013-5194
- SCHIZ J ET AL: "A novel self-aligned SiGe HBT structure using selective and non-selective epitaxy" HIGH PERFORMANCE ELECTRON DEVICES FOR MICROWAVE AND OPTOELECTRONIC APPLICATIONS, 1997. EDMO. 1997 WORKSHOP ON LONDON, UK 24-25 NOV. 1997, NEW YORK, NY, USA,IEEE, US, 24. November 1997 (1997-11-24), Seiten 255-260, XP010275420 ISBN: 0-7803-4135-X in der Anmeldung erwähnt
- BEHAMMER D ET AL: "Base contact resistance limits to lateral scaling of fully self-aligned double mesa SiGe-HBTs" SOLID STATE ELECTRONICS, ELSEVIER SCIENCE PUBLISHERS, BARKING, GB, Bd. 41, Nr. 8, 1. August 1997 (1997-08-01), Seiten 1105-1110, XP004083271 ISSN: 0038-1101 in der Anmeldung erwähnt
- HARAME D L ET AL: "SI/SIGE EPITAXIAL-BASE TRANSISTORS PART II: PROCESS INTEGRATION AND ANALOG APPLICATIONS" IEEE TRANSACTIONS ON ELECTRON DEVICES, IEEE INC. NEW YORK, US, Bd. 42, Nr. 3, 1. März 1995 (1995-03-01), Seiten 469-482, XP000493959 ISSN: 0018-9383 in der Anmeldung erwähnt

## Beschreibung

Die vorliegende Erfindung betrifft einen Bipolartransistor. Weiterhin betrifft die Erfindung ein Verfahren zum Herstellen eines Bipolartransistors.

Bipolartransistoren sind im allgemeinen aus zwei nahe beieinander liegenden pn-Übergängen in einem Halbleiterkristall aufgebaut. Dabei werden entweder zwei n-dotierte Gebiete durch ein p-dotiertes Gebiet voneinander getrennt (sogenannte npn-Transistoren) oder zwei p-dotierte durch ein n-dotiertes Gebiet (pnp-Transistoren). Die drei unterschiedlich dotierten Gebiete werden als Emitter (E), Basis (B) und Kollektor (C) bezeichnet. Bipolartransistoren sind bereits seit langem bekannt und werden auf vielfältige Art und Weise eingesetzt. Dabei unterscheidet man zwischen sogenannten Einzeltransistoren, die für die Montage auf Leiterplatten oder dergleichen gedacht und in einem eigenen Gehäuse untergebracht sind, und sogenannten integrierten Transistoren, die zusammen mit weiteren Halbleiterbauelementen auf einem gemeinsamen Halbleiterträger, der in der Regel als Substrat bezeichnet wird, hergestellt werden.

Die maximale Schwingfrequenz fₘₐₓ eines Bipolartransistors ist proportional zu der Wurzel aus f_{T} geteilt durch 8πR_{B}C_{BC}, wobei R_{B} der Basiswiderstand, C_{BC} die Basis- Collector-Kapazität und f_{T} die Transitfrequenz sind. Um hohe Schwingfrequenzen zu erhalten ist es deshalb wünschenswert den Basiswiderstand zu verringern. Der Basiswiderstand eines Bipolartransistors wird sowohl durch den Widerstand des Anschlußgebietes als auch durch den Schichtwiderstand des Basis-Dotierprofiles bestimmt. Dieser Schichtwiderstand, der sogenannte Pinch, ist bei homogener Basisdotierung umgekehrt proportional zur Basisdicke. Jedoch führt eine Erhöhung der Basisdicke zur Vergrößerung der Basislaufzeit für die Minoritätsträger.

Eine Erhöhung der homogenen Basisdotierung über 5 10¹⁸ hinaus verringert die Durchbruchsspannung des Emitter- Basis-übergangs auf zu niedrige Werte und vergrößert gleichzeitig die Kapazität der Basis-Emitter-Sperrschicht. Eine bekannte Methode zur weiteren Verringerung des Basis-Pinch-Widerstandes ist die Verwendung eines niedrig dotierten (1 10¹⁸), epitaktischen Emitters. Die niedrige Emitterdotierung erlaubt es die Basis praktisch bis 1 10²⁰ zu dotieren, ohne daß die Sperrfähigkeit des Emitter-Basis-Übergangs verloren geht. Wegen der im Vergleich zum Emitter erhöhten Basisladung wäre die Stromverstärkung eines solchen Transistors zu klein, dies kann jedoch durch die Verwendung von Germanium in der Basis ausgeglichen werden.

Bisherige Konzepte zur Erzeugung von Strukturen mit epitaktischem Emitter sind beispielsweise in Behammer et al., Solid State Electronics Vol 41, No.8, pp. 1105-1110 (1997) oder J. Schiz et al. IEEE (1997), ISBN 7803-4135-X, pp. 255 - 260 oder Patentdokument US-5 587 327 (König et al.), dargestellt und beschrieben.

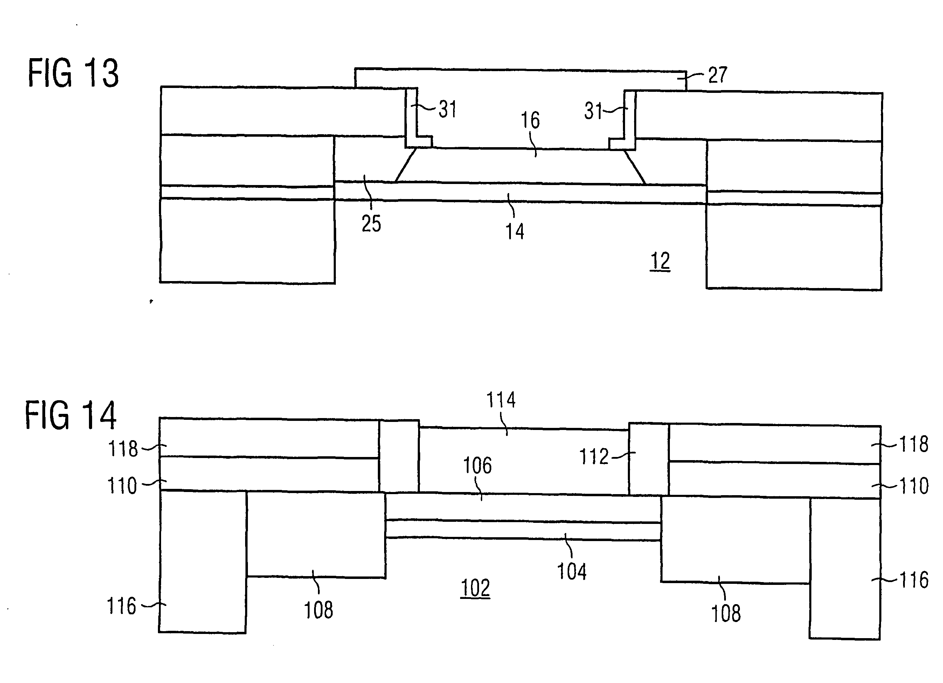

Fig. 14 zeigt schematisch einen Bipolartransitor gemäß der Veröffentlichung von Behammer et al. in vereinfachter Weise. Der Bipolartransistor weist zunächst einen Kollektor 102 auf, der in einem Siliziumsubstrat oder in einer Silizium Epitaxie-Schicht ausgebildet ist. Auf dem Kollektor 102 (n-dotiert) ist die SiGe-Basis 104 (p-dotiert) und auf der Basis 104 ist der n⁻-Emitter 106 vorgesehen. Seitlich angrenzend an den Kollektor 102, die Basis 104 und den n⁻-Emitter 106 ist eine p⁺ Implantation 108 angeordnet, die den Kontakt zur p-dotierten Basis herstellt. Zum Anschluß der p⁺ Implantation 108 ist eine Metallschicht 110 vorgesehen, die durch einen sogeannten Seitenwandspacer 112 von einem n⁺-Emitter 114 isoliert ist. Der n⁺-Emitter 114 wiederum ist oberhalb des n⁻-Emitter 106 angeordnet. Der gesamte Bipolartransistor ist durch eine Isolation 116 bzw. eine Isolationschicht 118 gegenüber weiteren Baulelementen isoliert.

Gemäß der Veröffentlichung von Behammer et al. kann der in Fig. 14 gezeigte Bipolartransistor mit Hilfe der sogenannten "Blanket Epitaxy" hergestellt werden. Bei diesem Verfahren erfolgt jedoch eine Trockenätzung auf dem Basisanschlußgebiet.

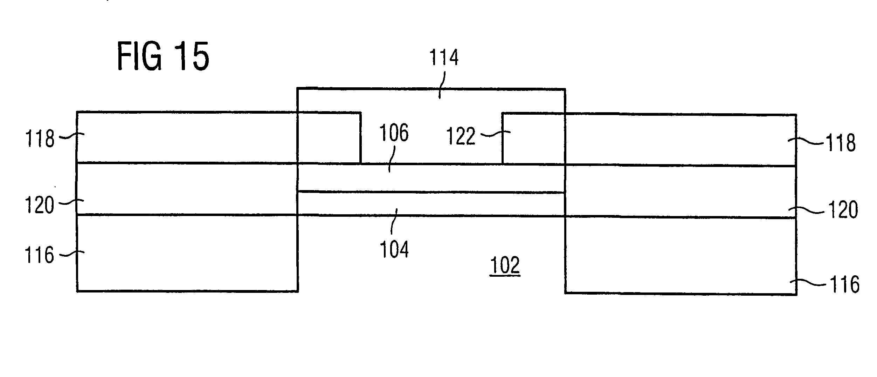

Fig. 15 zeigt schematisch einen Bipolartransitor gemäß der Veröffentlichung von J. Schiz et al. in vereinfachter Weise. Der Bipolartransistor 100 weist ebenfalls einen Kollektor 102 auf, der in einem Siliziumsubstrat oder in einer Silizium Epitaxie-Schicht ausgebildet ist. Auf dem Kollektor 102 (n-dotiert) ist die SiGe-Basis 104 (p-dotiert) und auf der Basis 104 ist der n⁻-Emitter 106 vorgesehen. Seitlich angrenzend an die Basis 104 und den n⁻-Emitter 106 ist eine p⁺-dotierte Polysiliziumschicht 120 angeordnet, die den Kontakt zur p-dotierten Basis herstellt. Über dem n⁻-Emitter 106 ist ein n⁺-Emitter 114 angeordnet, der von eimen justierten Seitenwandspacer 122 begrenzt wird. Der gesamte Bipolartransistor ist wiederum durch eine Isolation 116 bzw. eine Isolationschicht 118 gegenüber weiteren Baulelementen isoliert.

Der Bipolartransitor gemäß der Veröffentlichung von J. Schiz et al. muß den Seitenwandspacer 122 durch eine Fototechnik erzeugen, so daß eine Dicke von weniger als 200 µm in der Regel nicht möglich ist. Ein derart dicker Seitenwandspacer 122 hat jedoch deutlich erhöhte parasitäre Kapazitäten zur Folge.

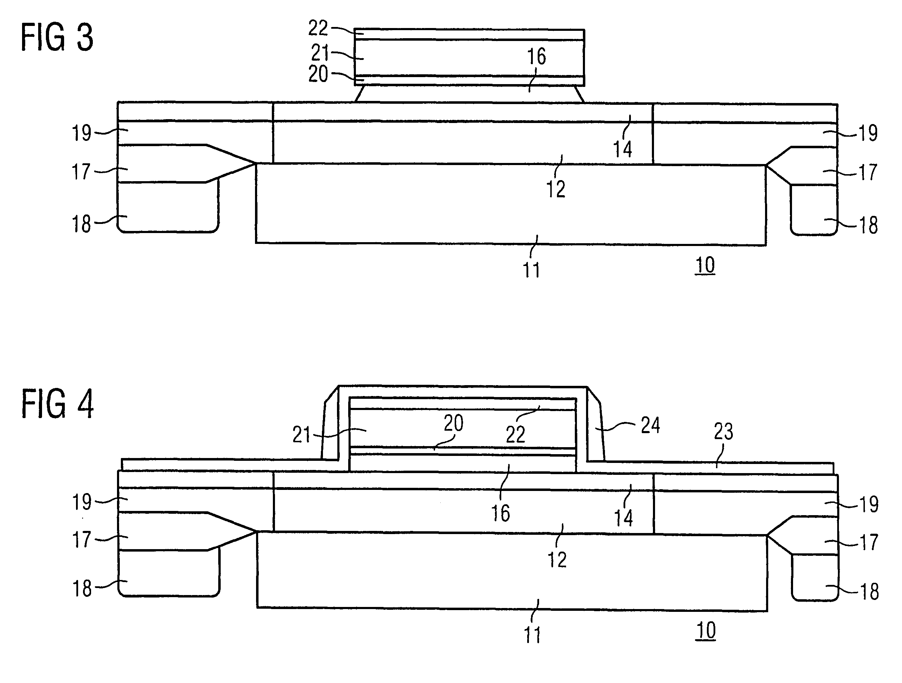

Die in den Figuren 14 und 15 gezeigten Bipolartransistoren besitzen als Gemeinsamkeit, daß eine sogenannte "Link-Implantation" (Kontakt-Implantation) außerhalb des Emitterbereichs durchgeführt wird, um den Basisanschlußwiderstand zu verringern. In einer weiteren Veröffentlichung von Harame et al., Trans. ED Vol. 42, No. 3, pp. 469 - 482 sind in der dortigen Fig. 3 die Implantationsschäden, Punkt-Defekte, dargestellt, die sich in der Regel bei einer deratigen Implatation, ebenso wie einer Trockenätzungen auf Siliziumsubstrat, ergeben.

Auch wenn man davon ausgeht, daß keine Ausdehnung der Punkt-Defekte in das aktive Basisgebiet stattfindet, so führen die vorhandene Punkt-Defekte doch zu einer anormal hohen Diffusion des Dotierstoffs Bor in die nahegelegenen SiGe-Basis 104. Um eine derartige Dotierstoffdiffusion zu verhindern, kann der Seitenwandspacer nicht beliebig dünn gemacht werden. Um die Punktdefekte von der Basis fern zu halten ist ein Seitenwandspacer von ca. 150 nm und größer notwendig, was jedoch den Linkwiderstand und die Basis-Collector Kapazität erhöht. Für den Fall, daß der Seitenwandspacer vollstandig weggelassen wird und zusätzlich in den Anschlußbereich implantiert wird, ist kein funktionierendes Bauelement zu erwarten. Weiterhin kommt es während nachfolgender Temperaturschritte oberhalb 550°C infolge der noch vorhandenen Punktdefekte zu einer starken Verbreiterung des Basisprofils.

Es ist daher die Aufgabe der vorliegenden Erfindung, einen Bipolartransistor sowie ein Verfahren zu dessen Herstellung bereitzustellen, der die geschilderten Schwierigkeiten deutlich vermindert bzw. ganz vermeidet. Es ist insbesondere die Aufgabe der vorliegenden Erfindung, einen Bipolartransistor bereitzustellen, der einen niedrigen Basisanschlußwiderstand sowie eine geringe Defektdichte aufweist.

Diese Aufgabe wird von dem Verfahren zur Herstellung eines Bipolartransitors gemäß Patentanspruch 1 sowie von dem Bipolartransistor gemäß Patentanspruch 10 gelöst. Weitere vorteilhafte Ausführungsformen, Ausgestaltungen und Aspekte der vorliegenden Erfindung ergeben sich aus den Unteransprüchen der Beschreibung und den beiliegenden Zeichnungen.

Erfindungsgemäß wird ein Verfahren zur Herstellung eines Bipolartransistor, insbesondere eines npn - Bipolartransistors, mit den folgenden Schritten bereitgestellt:
a) ein Halbleitersubstrat mit einem Kollektor, einer Basis und einer niedrig-dotierten Emitterschicht wird bereitgestellt;
b) auf die niedrig-dotierte Emitterschicht wird eine Maske aufgebracht;
c) mit Hilfe der Maske wird die niedrig dotierte Emitterschicht naßchemisch geätzt, so daß ein niedrig-dotierten Emitter gebildet wird;
d) auf den freiliegenden Bereichen der Basis wird der Basisanschluß gebildet;
e) die Maske wird entfernt und ein hoch-dotierter Emitter gebildet.

Weiterhin wird erfindungsgemäß ein Bipolartransistor, insbesondere npn-Bipolartransistor, mit einem Halbleitersubstrat, einem Kollektor, einer Basis, einem niedrig-dotierten Emitter und einem hoch-dotierten Emitter bereitgestellt. Der erfindungsgemäße Bipolartransistor ist **dadurch gekennzeichnet, daß** der Anschluß an die Basis im wesentlichen parallel zu dem niedrig-dotierten Emitter ausgerichtet und vom dem niedrig-dotierten Emitter durch einen Seitenwandspacer oder, einen pn-Übergang getrennt ist.

Durch das erfindungsgemäße Verfahren kann ein Bipolartransistor mit niedrigem Basisanschlußwiderstand, geringer Defektdichte und verbesserter Skalierbarkeit hergestellt werden. Unter Skalierbarkeit ist hierbei sowohl die laterale Skalierung des Emitterfensters als auch die vertikale Skalierung der Basisweite (niedriges Temperaturbudget) zu verstehen. Das Temperaturbudget kann im Basisbereich niedrig gehalten werden, da keine Implantationen notwendig sind, um den Basisanschlußwiderstand zu verringern. Weiterhin werden die mit den Punkt-Defekten in Zusammenhang stehenden Schwierigkeiten weitgehend vermieden.

Gemäß einer bevorzugten Ausführungsform wird als Basis eine hoch-dotierte Silizium-Germanium Basis verwendet. Durch die Verwendung von Germanium in der Basis kann eine ausreichende Stromverstärkung des Bipolartransistors trotz einer erhöhten Basisladung gewährleistet werden.

Bevorzugt weist die Basis eine Dicke von 20 bis 50nm sowie eine Dotierung, insbesondere eine p⁺-Dotierung, von mehr als 2 10¹⁹ pro Kubikcentimeter auf. Weiterhin ist es bevorzugt, wenn der niedrig-dotierte Emitter eine Dicke von 50 bis 150nm sowie eine n⁻-Dotierung von weniger als 2 10¹⁸ pro Kubikcentimeter aufweist.

Gemäß einer weiteren bevorzugten Ausführungsform umfaßt die Maske eine Oxid-Schicht, eine Siliziumschicht und eine Nitridschicht. Dabei ist es bevorzugt, wenn die Oxidschicht (Oxid-Stoppschicht) mit Hilfe eines CVD-Verfahrens auf die niedrig-dotierte Emitterschicht aufgebracht wird. Die Dicke der Stoppschicht beträgt bevorzugt 5 bis 30 nm. Auf die Oxidschicht wird eine, bevorzugt p⁺-dotierte, amorphe Siliziumschicht mit einer Dicke von 100 bis 1000 nm aufgebracht. Es folgt die Nitridschicht, die durch ein Sputterverfahren mit einer Dicke von 20 bis 50 nm abgeschieden wird. Die kombinierte Schicht aus Nitrid und amorphen Silizium kann nachfolgend fototechnisch in der Breite des Emitterfensters durch Trockenätzen strukturiert werden. Die Oxidschicht dient hierbei als Ätzstop, da sich amorphes Silizium sehr selektiv (>10) zu Oxid ätzen läßt. Das Oxid kann nachfolgend durch HF entfernt werden.

Weiterhin ist es bevorzugt, wenn die niedrig-dotierte Emitterschicht naßchemisch mit einem alkalischen Ätzmittel, insbesondere KOH, Cholin und/oder Ethylendiamin, geätzt wird. Eine naßchemisch Ätzung mit einem alkalischen Ätzmittel, insbesondere KOH, Cholin und/oder Ethylendiamin, besitzt den Vorteil, daß selektiv zwischen n- und p- Silizium geätzt wird. Somit kann die niedrig-dotierte Emitterschicht selektiv zu der Basis strukturiert werden. Weiterhin besitzt eine naßchemisch Ätzung den Vorteil, daß hierbei keine Defekte in der darunter liegenden Basis erzeugt werden.

Gemäß einer weiteren bevorzugten Ausführungsform ist die niedrig-dotierte Emitterschicht über der Basis als im wesentlichen monokristalline Schicht ausgebildet und die näßchemische Ätzung stoppt auf (111)-Flächen in dieser im wesentlichen monokristallinen Schicht. Insbesondere eine naßchemisch Ätzung mit KOH oder Cholin besitzt den Vorteil, daß die Ätzung auf (111)-Flächen stoppt, die sich bei Unterätzung entlang von (110) Kanten auf einer (100)-Oberfläche ausbilden. Dies ist auch die übliche Flat und Substrat Orientierung bei Siliziumscheiben.

Gemäß einer weiteren bevorzugten Ausführungsform wird vor der naßchemischen Ätzung an den Seitenwänden der Maske ein Seitenwandspacer, bevorzugt ein Nitridspacer, erzeugt.

Gemäß einer weiteren bevorzugten Ausführungsform wird vor der Bildung des Basisanschlusses an den Seitenwänden der Maske und des niedrig-dotierten Emitters ein Seitenwandspacer, bevorzugt ein Nitridspacer, erzeugt. Um auch hier eine Trockenätzung auf der Basis zu vermeiden, wird zunächst die Nitridschicht, bevorzugt 5 bis 50 nm, abgeschieden und dann ein Oxidspacer durch Trockenätzung erzeugt. Das Nitrid wird nun naßchemisch, bevorzugt durch Phosphorsäure, selektiv zum Oxid entfernt, so daß nur die von dem Oxidspacer geschützten Bereiche der Nitrid-Schicht bestehen bleiben. Wird der Oxidspacer anschließend mit HF entfernt bilden diese Bereiche der Nitrid-Schicht den Seitenwandspacer.

Gemäß einer weiteren bevorzugten Ausführungsform wird auf den freiliegenden Bereichen der Basis der Basisanschluß mittels differentieller Epitaxy gebildet. Dabei ist insbesondere bevorzugt, wenn als Basisanschluß ein hoch-dotierter (> 1 10²⁰), insbesondere ein P+ dotierter, Basisanschluß verwendet wird. Die selektive Epitaxy erfolgt dabei bevorzugt bei etwa der Temperatur mit der auch die Basis selbst erzeugt wurde (beispielsweise etwa 800°C). Dementsprechend kommt es hierbei zu keiner wesentlichen Verbreiterung der Dotierprofile.

Gemäß einer weiteren bevorzugten Ausführungsform wird vor der Bildung des hoch-dotierten Emitters an den Seitenwänden Emitterfensters ein Seitenwandspacer, bevorzugt ein Nitridspacer, erzeugt.

Die Erfindung wird nachfolgend anhand der Figuren der Zeichnungen näher dargestellt. Es zeigen
- Fig. 1 bis 9: eine schematische Darstellung einer ersten Ausführungsform des erfin- dungsgemäßen Verfahrens,
- Fig. 10 bis 13: eine schematische Darstellung einer zweiten Ausführungsform des erfin- dungsgemäßen Verfahrens,
- Fig. 14: schematisch einen Bipolartransitor gemäß der Veröffentlichung von Be- hammer et al. in vereinfachter Wei- se, und
- Fig. 15: schematisch einen Bipolartransitor gemäß der Veröffentlichung von J. Schiz et al. in vereinfachter Weise.

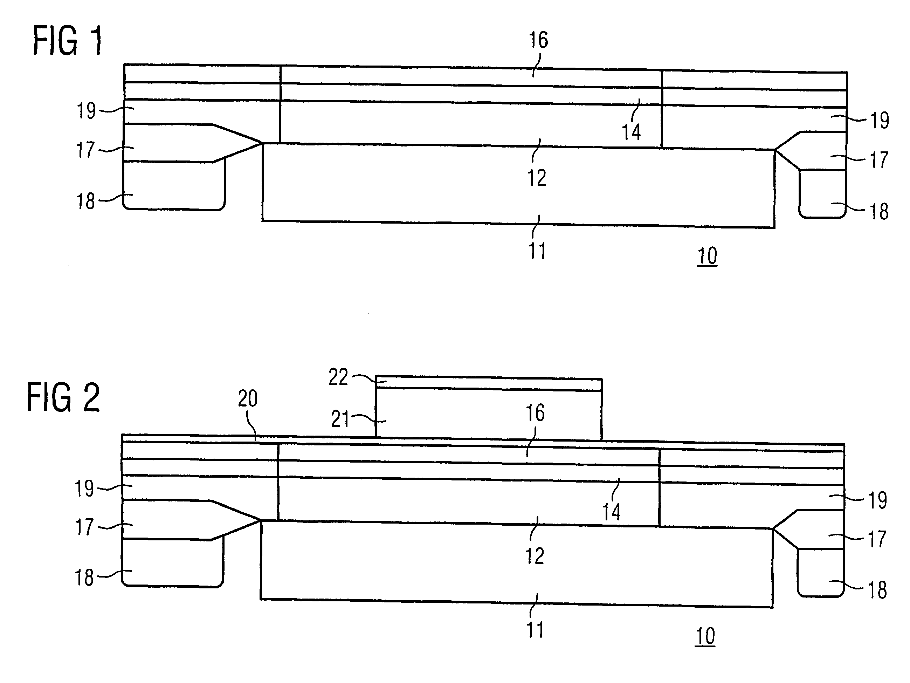

Die Figuren 1 bis 9 zeigen nachfolgend eine schematische Darstellung einer ersten Ausführungsform des erfindungsgemäßen Verfahrens. Gemäß Schritt a) des erfindungsgemäßen Verfahrens wird ein Siliziumsubstrat 10 mit einem Kollektor 12, einer Basis 14 und einer niedrig-dotierten Emitterschicht 16 bereitgestellt. Um den elektrischen Anschluß des Kollektors 12 zu gewährleisten, steht der Kollektor 12 mit einer vergrabenen Schicht 11 in Kontakt. Weiterhin sind zur Isolation des späteren Bipolartransistors eine Isolation 17, im vorliegenden Beispiel eine LOCOS-Isolation, und ein sogenannter "Channel Stop" 18 unterhalb der Isolation 17 vorgesehen.

Ausgehend von dem Siliziumsubstrat 10 mit der vergrabenen Schicht 11 wird, beispielsweise mit selektiver Epitaxy, der Kollektor 12 auf der vergrabenen Schicht 11 erzeugt. Dabei wird der Kollektor 12 lateral von einer Isolationschicht 19, beispielsweise einer TEOS-Schicht, begrenzt. Anschließend erfolgt, beispielsweise mit einer differentiellen Epitaxy, Abscheidung einer hoch-dotierten Silizum-Germanium Basis 14 sowie einer niedrig-dotierten Emitterschicht 16. Bevorzugt weist die Basis 14 eine Dicke von 20 bis 50nm sowie eine p⁺-Dotierung, von mehr als 2 10¹⁹ pro Kubikcentimeter auf. Der niedrig-dotierte Emitter 16 besitzt eine Dicke von 50 bis 150nm sowie eine n⁻-Dotierung von weniger als 2 10¹⁸ pro Kubikcentimeter. Die sich daraus ergebende Situation ist in Fig. 1 gezeigt.

Anschließend erfolgt die Abscheidung einer CVD-Oxid-Stopschicht 20. Die Dicke der Oxid-Stopschicht 20 beträgt dabei zwischen 5 und 30 nm. Die Abscheidung erfolgt bei einer Temperatur von beispielsweise 600°C. Es folgt die Abscheidung einer hoch-dotierten (P⁺) amorphen Siliziumschicht 21. Die Dicke der amorphen Siliziumschicht 21 beträgt dabei zwischen 100 und 1000 nm. Die Abscheidung erfolgt bei einer Temperatur von beispielsweise 550°C. Weiterhin wird eine gesputterte Nitridschicht 22 mit einer Dicke von etwa 35 nm aufgebracht.

Anschließend werden die Nitridschicht 22 und die amorphe Siliziumschicht 21 fototechnisch in der Breite des Emitterfensters durch Trockenätzen strukturiert. Die Oxidschicht 20 dient hierbei als Ätzstop, da sich amorphes Silizium sehr selektiv (>10) zu Oxid ätzen läßt. Das Oxid 20 wird nachfolgend durch HF entfernt werden. Die sich daraus ergebende Situation ist in Fig. 2 gezeigt.

Ein wesentlicher Teil des erfindungsgemäßen Verfahrens besteht nun darin, die niedrig-dotierten Emitterschicht 16 über der Basis 14 durch eine Naßätzung zu strukturieren. Der Schichstapel aus Oxidschicht 20, amorpher Siliziumschicht 21 und Nitridschicht 22 wirkt dabei als Maske für die Strukturierung. Dabei ist es bevorzugt, wenn die niedrig-dotierte Emitterschicht 16 naßchemisch mit KOH oder Cholin geätzt wird. Eine naßchemisch Ätzung mit KOH oder Cholin besitzt den Vorteil, daß KOH oder Cholin selektiv zwischen n- und p- Silizium ätzt. Somit kann die niedrig-dotierte Emitterschicht 16 selektiv zu der Basis 14 und der bereits strukturierten, amorphen Siliziumschicht 21 strukturiert werden. Weiterhin besitzt eine naßchemisch Ätzung mit KOH oder Cholin den Vorteil, daß hierbei keine Defekte in der darunter liegenden Basis 14 erzeugt werden.

Da die niedrig-dotierte Emitterschicht 16 über der Basis 14 als im wesentlichen monokristalline Schicht ausgebildet ist, stoppt die näßchemische Ätzung mit KOH oder Cholin auf (111)-Flächen die sich bei einer Unterätzung entlang von (110) Kanten auf einer (100)-Oberfläche ausbilden. Dies ist auch die übliche Flat und Substrat Orientierung bei Siliziumscheiben. Auf diese Weise wird der niedrig-dotierte Emitter 16 gebildet, der lateral (bis auch Eckbereiche) durch (111)-Flächen begrenzt ist. Die sich daraus ergebende Situation ist in Fig. 3 gezeigt.

Die Seitenwand des niedrig-dotierten Emitters wird nun durch einen Nitridspacer 23 isoliert. Um auch hier eine Trokkenätzung auf der Basis 14 zu vermeiden, wird zunächst die Nitridschicht 23 mit einer Dicke zwischen 5 und 50 nm abgeschieden und dann ein Oxidspacer 24 durch eine Oxidabescheidung, beispielsweise TEOS, und eine anschließende Trockenätzung strukturiert. Die sich daraus ergebende Situation ist in Fig. 4 gezeigt. Aus Gründen der Einfachheit sind in Fig. 4 und in den folgendenden Figuren die (111)-Stopflächen, die den niedrig-dotierte Emitter 16 lateral begrenzen, nicht mehr dargestellt.

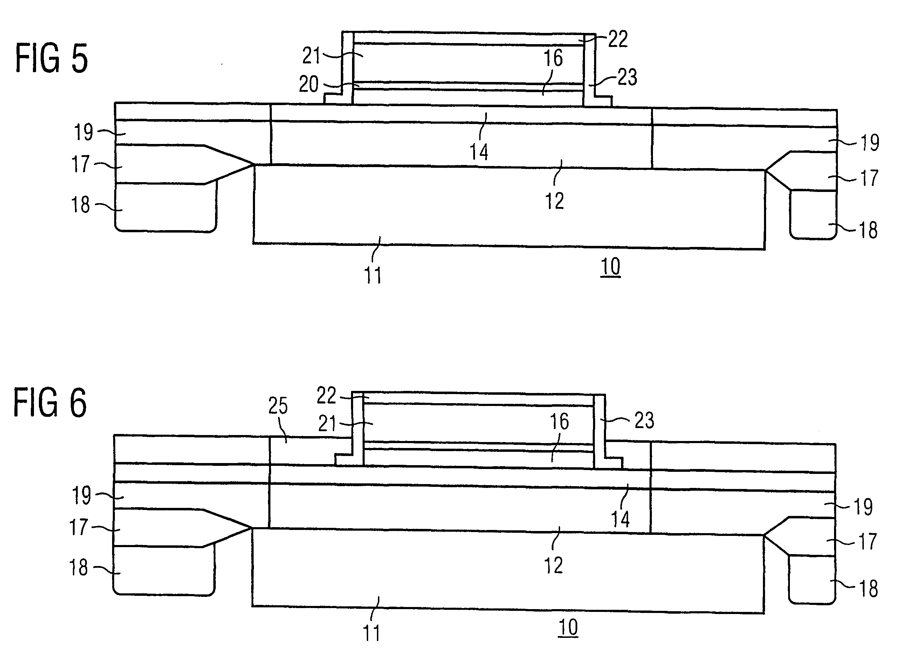

Anschließend wird die Nitridschicht 23 naßchemisch, bevorzugt durch Phosphorsäure, selektiv zum Oxid 24 entfernt, so daß nur die von dem Oxidspacer 24 geschützten Bereiche der Nitrid-Schicht 23 bestehen bleiben. Nachfolgend wird der Oxidspacer 24 mit HF entfernt, so daß diese von dem Oxidspacer geschützten Bereiche der Nitrid-Schicht den Seitenwandspacer 23 bilden. Die sich daraus ergebende Situation ist in Fig. 5 gezeigt.

Anschließend wird auf den freiliegenden Bereichen der Basis der Basisanschluß 25 mittels differentieller Epitaxy gebildet. Dabei ist insbesondere bevorzugt, wenn als Basisanschluß ein hoch-dotierter (> 1 10²⁰), insbesondere ein P+ dotierter, Basisanschluß 25 verwendet wird. Die selektive Epitaxy erfolgt dabei bevorzugt bei etwa der Temperatur mit der auch die Basis 14 selbst erzeugt wurde (beispielsweise etwa 800°C). Dementsprechend kommt es hierbei zu keiner wesentlichen Verbreiterung der Dotierprofile. Die sich daraus ergebende Situation ist in Fig. 6 gezeigt.

Der Anschluß 25 an die Basis ist somit im wesentlichen parallel zu dem niedrig-dotierten Emitter 16 ausgerichtet, d.h. die wesentliche Kontaktfläche, mit der die Basis 14 mit dem Basisanschluß 25 in Kontakt steht, ist parallel zu der Kontaktfläche orientiert, mit welcher der niedrig-dotierte Emitter 16 mit der Basis 14 in Kontakt steht. Dabei ist der Basisanschluß 25 vom dem niedrig-dotierten Emitter durch den Seitenwandspacer 23 getrennt. Da der einkristalline Bereich des Basisanschlusses 25 im wesentlichen defektfrei ist, ist es möglich, den Seitenwandspacer 23 sehr dünn zu machen.

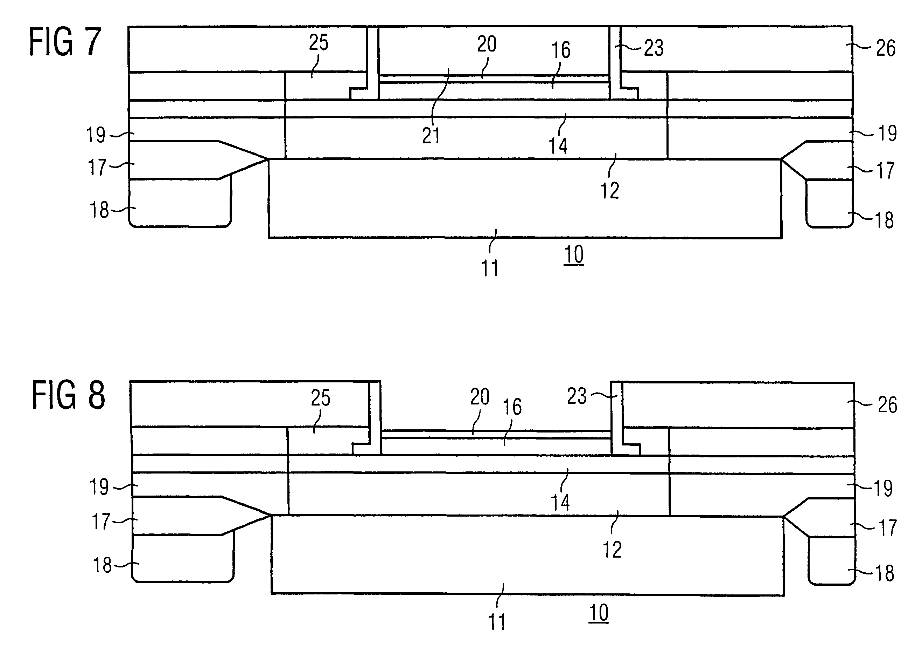

Wie in Fig.7 gezeigt, erfolgt nun die Abscheidung eines CVD-Oxids 26 und dessen Planarisierung. Dabei wird die verbliebene Nitridschicht 22 über dem Emitterfenster wegpoliert. Anschließend erfolgt die selbjustierte Entfernung der Opferschichten im Emitterfenster. Dabei erfolgt die Entfernung der amorphen Siliziumschicht 21 im Emitterfenster durch eine Trockenätzung, wobei das etwa CVD-Oxid 20 wiederum als Ätzstop dient (Fig.8).

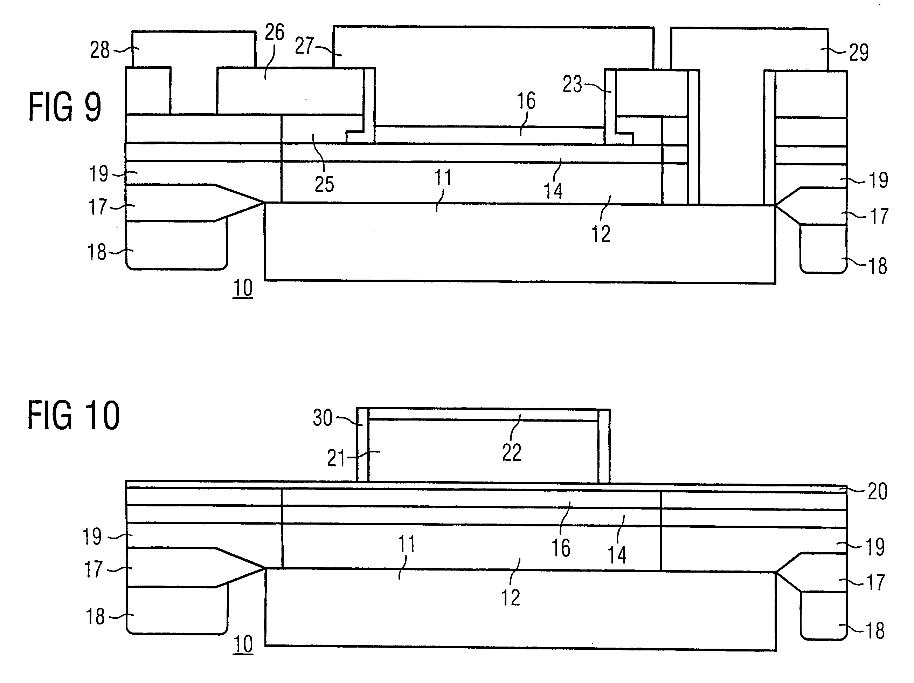

Nachdem durch Naßätzen mit HF die Oxidschicht 20 ebenfalls entfernt wurde, erfolgt die Abscheidung des n+ Emitterpolys 27 sowie dessen Strukturierung. Anschließend werden in üblicherweise der Basiskontakt 28 sowie der Kollektorkontakt 29 erzeugt Die sich daraus ergebende Situation ist in Fig. 9 gezeigt.

Im Gegensatz zu dem in Fig. 14 gezeigten Biloartransistor nach dem Stand der Technik besitzt der in Fig. 9 gezeigte, erfindungsgemäße Bipolatransistor einen bis zur Basis nach unten durchgehenden Seitenwandspacer 23, der zumindest teilweise von einem im wesentlichen monokristallinen Basisanschluß 25 umgeben ist. Bei dem in Fig. 14 gezeigten Biloartransistor nach dem Stand der Technik schließt der monokristalline P+ dotierte Bereich auf der Höhe des n-Emitters ab und reicht tief unter die Basis, während beim dem in Fig. 9 gezeigten, erfindungsgemäßen Bipolatransistor die Isolation auf der Unterkante der Basis beginnt und der monokristalline Bereich des Basisanschlußes 25 sicher oberhalb der Basis-Oberkante liegt. Da der einkristalline Basisanschluß 25 zur Basis 14 im wesentlichen defektfrei ist, ist es möglich, den Seitenwandspacer 23 sehr dünn auszubilden.

Die Figuren 10 bis 13 zeigen nachfolgend eine schematische Darstellung einer zweiten Ausführungsform des erfindungsgemäßen Verfahrens. Die ersten Prozeßschritte dieser zweiten Ausführungsform entsprechen dabei den Prozeßschritten, die bereits in Zusammenhang mit den Figuren 1 und 2 beschrieben worden sind, so daß auf eine Wiederholung verzichtet werden kann.

Nach der Strukturierung der Nitridschicht 22 und der amorphen Siliziumschicht 21 durch eine Trockenätzung wird an den Seitenwänden der Nitridschicht 22 und der amorphen Siliziumschicht 21 ein Nitridspacer 30 erzeugt. Die Oxidschicht 20 dient hierbei wiederum als Ätzstop. Die sich daraus ergebende Situation ist in Fig. 10 gezeigt. Anstelle eines Schichtstapels aus Silizium und Siliziumnitrid kann auch eine Maske verwendet werden, die ausschließlich aus Siliziumnitrid besteht. Dies hätte den Vorteil, daß nur zwei Materialien selektiv zueinander geätzt werden müssen. Nachfolgend wird das Oxid 20 durch HF entfernt.

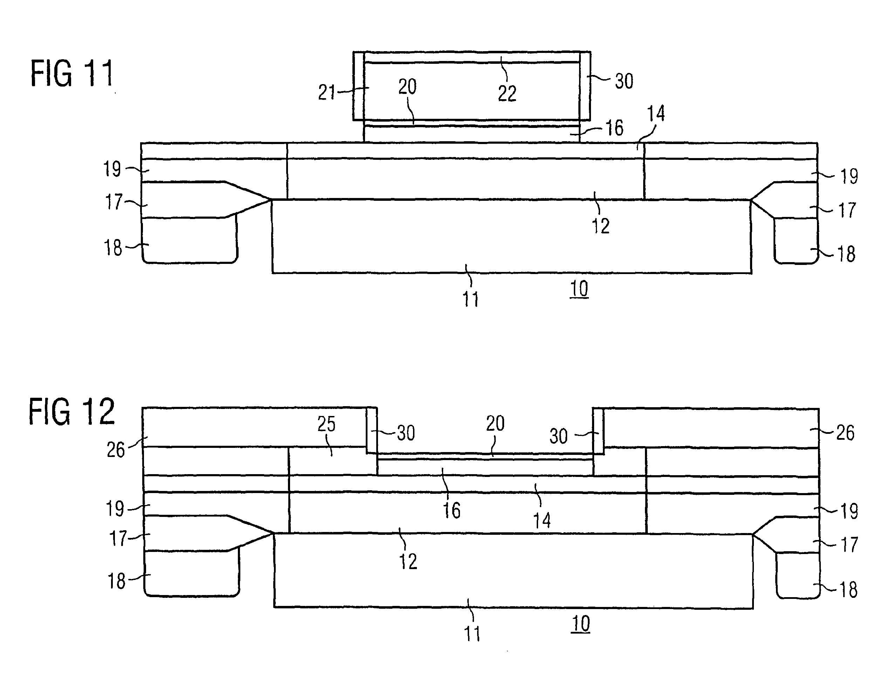

Anschließend wird die niedrig-dotierten Emitterschicht 16 über der Basis 14 durch eine Naßätzung zu strukturieren. Der Schichstapel aus Oxidschicht 20, amorpher Siliziumschicht 21 und Nitridschicht 22 wirkt dabei als Maske für die Strukturierung. Dabei ist es wiederum bevorzugt, wenn die niedrig-dotierte Emitterschicht 16 naßchemisch mit KOH oder Cholin geätzt wird. Da die niedrig-dotierte Emitterschicht 16 über der Basis 14 als im wesentlichen monokristalline Schicht ausgebildet ist, stoppt die näßchemische Ätzung mit KOH oder Cholin auf (111)-Flächen die sich bei einer Unterätzung entlang von (110) Kanten auf einer (100)-Oberfläche ausbilden. Die sich daraus ergebende Situation ist in Fig. 11 gezeigt.

Anschließend wird auf den freiliegenden Bereichen der Basis der Basisanschluß 25 mittels differentieller Epitaxy gebildet. Dabei ist insbesondere bevorzugt, wenn als Basisanschluß ein hoch-dotierter (> 1 10²⁰), insbesondere ein P+ dotierter, Basisanschluß 25 verwendet wird. Die selektive Epitaxy erfolgt dabei bevorzugt bei etwa der Temperatur mit der auch die Basis 14 selbst erzeugt wurde (beispielsweise etwa 800°C). Dementsprechend kommt es hierbei zu keiner wesentlichen Verbreiterung der Dotierprofile. Da bei dieser Ausführungsform der Seitenwandspacer 30 im Bereich des niedrig-dotierten Emitters 16 nicht vorhanden ist, ist der Anschluß 25 an die Basis 14 vom dem niedrig-dotierten Emitter 16 durch einen pn-Übergang getrennt.

Anschließend erfolgt nun die Abscheidung eines CVD-Oxids 26 und dessen Planarisierung. Dabei wird die verbliebene Nitridschicht 22 über dem Emitterfenster wegpoliert. Anschließend erfolgt die selbjustierte Entfernung der Opferschichten im Emitterfenster. Dabei erfolgt die Entfernung der amorphen Siliziumschicht 21 im Emitterfenster durch eine Trockenätzung, wobei das etwa CVD-Oxid 20 wiederum als Ätzstop dient. Die sich daraus ergebende Situation ist in Fig. 12 gezeigt.

Es folgt die Erzeugung eines weiteren Seitenwandspacers 31 (z.B. Nitridspacer), um einen ausreichenden Abstand zwischen dem Basisanschluß 25 und dem noch zu erzeugenden n+ Emitter zu gewährleisten. Nachdem durch Naßätzen mit HF die Oxidschicht 20 ebenfalls entfernt wurde, erfolgt die Abscheidung des n+ Emitterpolys 27 sowie dessen Strukturierung. Die sich daraus ergebende Situation ist in Fig. 13 gezeigt.

Im Gegensatz zu dem in Fig. 15 gezeigten Biloartransistor nach dem Stand der Technik ist bei dem in Fig. 13 gezeigte, erfindungsgemäße Bipolatransistor ein Teil des Basisanschlusses 25 im wesentlichen einkristallin und bildet einen pn-Übergang mit den (111)-Stoppflächen des niedrig-dotierten Emitters 16. Bei dem in Fig. 15 gezeigten Biloartransistor nach dem Stand der Technik muß der Seitenwandspacer durch eine Fototechnik erzeugt werden, so daß eine Dicke von weniger als 200 um in der Regel nicht möglich ist. Dies hat höhere parasitäre Kapazitäten zur folge. Bei dem in Fig. 13 gezeigte, erfindungsgemäße Bipolatransistor kann der nach innen gerichtete Seitenwandspacers 31 selbstjustiert in das bereits vorhandene Emitterloch eingebracht werden und damit auch sehr dünn, beispielsweise dünner als 50 nm, gemacht werden.

## Patentansprüche

1. Verfahren zur Herstellung eines Bipolartransistor, insbesondere eines npn-Bipolartransistors, mit den Schritten:
a) ein Halbleitersubstrat mit einem Kollektor, einer Basis und einer niedrig-dotierten Emitterschicht wird bereitgestellt;
b) auf die niedrig-dotierte Emitterschicht wird eine Maske aufgebracht;
c) mit Hilfe der Maske wird die niedrig dotierte Emitterschicht naßchemisch geätzt, so daß ein niedrig-dotierten Emitter gebildet wird;
d) auf den freiliegenden Bereichen der Basis wird ein Basisanschluß gebildet;
e) die Maske wird entfernt und ein hoch-dotierter Emitter gebildet.

2. Verfahren nach Anspruch 1,
**dadurch gekennzeichnet, dass**
als Basis eine hoch-dotierte Silizium-Germanium Basis verwendet wird.

3. Verfahren nach Anspruch 1 oder 2,
**dadurch gekennzeichnet, dass**
die Maske ein Oxid-Schicht, eine Siliziumschicht und eine Nitridschicht umfaßt.

4. Verfahren nach einem der vorherstehenden Ansprüche,
**dadurch gekennzeichnet, dass**
die niedrig-dotierte Emitterschicht naßchemisch mit einem alkalischen Atzmittel, insbesondere KOH, Cholin und/oder Ethylendiamin, geätzt wird.

5. Verfahren nach einem der vorherstehenden Ansprüche,
**dadurch gekennzeichnet, dass**
die niedrig-dotierte Emitterschicht über der Basis als im wesentlichen monokristalline Schicht ausgebildet ist und die näßchemische Ätzung auf (111)-Flächen in dieser im wesentlichen monokristallinen Schicht stoppt.

6. Verfahren nach einem der vorherstehenden Ansprüche,
**dadurch gekennzeichnet, dass**
vor der naßchemischen Ätzung an den Seitenwänden der Maske ein Seitenwandspacer, bevorzugt ein Nitridspacer, erzeugt wird.

7. Verfahren nach einem der Ansprüche 1 bis 5,
**dadurch gekennzeichnet, dass**
vor der Bildung des Basisanschlusses an den Seitenwänden der Maske und des niedrig-dotierten Emitters ein Seitenwandspacer, bevorzugt ein Nitridspacer, erzeugt wird.

8. Verfahren nach einem der vorherstehenden Ansprüche,
**dadurch gekennzeichnet, dass**
auf den freiliegenden Bereichen der Basis der Basisanschluß mittels selektiver Epitaxy gebildet wird.

9. Verfahren nach einem der vorherstehenden Ansprüche,
**dadurch gekennzeichnet, dass**
vor der Bildung des hoch-dotierten Emitters an den Seitenwänden Emitterfensters ein Seitenwandspacer, bevorzugt ein Nitridspacer, erzeugt wird.

10. Bipolartransistor, insbesondere npn-Bipolartransistor, mit einem Halbleitersubstrat (10), einem Kollektor (12), einer Basis (14), einem niedrig-dotierten Emitter (16) und einem hoch-dotierten Emitter (27),
**dadurch gekennzeichnet, dass**
der einkristalline Bereich des Basisanschlußes (25) im wesentlichen parallel zu dem niedrig-dotierten Emitter (16) ausgerichtet, vom dem niedrig-dotierten Emitter (16) durch einen Seitenwandspacer (23) oder einen pn-Übergang getrennt und zumindest bereichweise auf der Basis (14) ausgebildet ist.

11. Bipolartransistor nach Anspruch 10,
**dadurch gekennzeichnet, dass**
die Basis (14) als eine hoch-dotierte Silizium-Germanium Basis ist.

12. Bipolartransistor nach Anspruch 10 oder 11,
**dadurch gekennzeichnet, dass**
die Basis (14) eine Dotierung, insbesondere eine p⁺-Dotierung, von mehr als 2 10¹⁹ pro Kubikcentimeter aufweist.

13. Bipolartransistor nach einem der Ansprüche 10 bis 12,
**dadurch gekennzeichnet, dass**
der niedrig-dotierten Emitter (16) eine Dotierung, insbesondere eine n-Dotierung, von weniger als 2 10¹⁸ pro Kubikcentimeter aufweist.

14. Bipolartransistor nach einem der Anspruche 10 bis 13,
**dadurch gekennzeichnet, dass**
der niedrig-dotierten Emitter (16) als im wesentlichen monokristalline Schicht ausgebildet und lateral durch (111)-Flächen begrenzt ist.

15. Bipolartransistor nach einem der Ansprüche 10 bis 14,
**dadurch gekennzeichnet, dass**
der Seitenwandspacer (23) als ein Nitridspacer ausgebildet ist.

16. Bipolartransistor nach einem der Ansprüche 10 bis 15,
**dadurch gekennzeichnet, dass**
der Basisanschluß (25) ein hoch-dotierter, insbesondere ein P+ dotierter, Basisanschluß ist.

17. Bipolartransistor nach einem der Ansprüche 10 bis 16,
**dadurch gekennzeichnet, dass**
der Kollektor (12) mit einer vergrabenen Schicht (11) in Kontakt steht.

## Claims

1. Method for fabricating a bipolar transistor, in particular an npn bipolar transistor, having the following steps:
a) a semiconductor substrate with a collector, a base and a lightly doped emitter layer is provided;
b) a mask is applied to the lightly doped emitter layer;
c) the lightly doped emitter layer is etched wet-chemically with the aid of the mask, thereby forming a lightly doped emitter;
d) a base connection is formed on the uncovered regions of the base;
e) the mask is removed and a highly doped emitter is formed.

2. Method according to Claim 1,
**characterized in that**
a highly doped silicon-germanium base is used as the base.

3. Method according to Claim 1 or 2,
**characterized in that**
the mask comprises an oxide layer, a silicon layer and a nitride layer.

4. Method according to one of the preceding claims,
**characterized in that**
the lightly doped emitter layer is etched wet-chemically using an alkaline etchant, in particular KOH, choline and/or ethylenediamine.

5. Method according to one of the preceding claims,
**characterized in that**
the lightly doped emitter layer is formed above the base as an essentially monocrystaline layer and the wet-chemical etching stops on (111) faces in said essentially monocrystaline layer.

6. Method according to one of the preceding claims,
**characterized in that**
a sidewall spacer, preferably a nitride spacer, is produced before the wet-chemical etching on the side walls of the mask.

7. Method according to one of Claims 1 to 5,
**characterized in that**
a sidewall spacer, preferably a nitride spacer, is produced before the formation of the base connection on the side walls of the mask and of the lightly doped emitter.

8. Method according to one of the preceding claims,
**characterized in that**
the base connection is formed by means of selective epitaxy on the uncovered regions of the base.

9. Method according to one of the preceding claims,
**characterized in that**
a sidewall spacer, preferably a nitride spacer, is produced before the formation of the highly doped emitter on the side walls of the emitter window.

10. Bipolar transistor, in particular an npn bipolar transistor, with a semiconductor substrate (10), a collector (12), a base (14), a lightly doped emitter (16) and a highly doped emitter (27),
**characterized in that**
the monocrystalline region of the base connection (25) is oriented essentially parallel to the lightly doped emitter (16) and is isolated from the lightly doped emitter (16) by a sidewall spacer (23) or a pn junction and is formed at least in regions on the base (14).

11. Bipolar transistor according to Claim 10,
**characterized in that**
the base (14) is designed as a highly doped silicon-germanium base.

12. Bipolar transistor according to Claim 10 or 11,
**characterized in that**
the base (14) has a doping, in particular a p⁺-type doping, of more than 2 10¹⁹ per cubic centimeter.

13. Bipolar transistor according to one of Claims 10 to 12,
**characterized in that**
the lightly doped emitter (16) has a doping, in particular an n-type doping, of less than 2 10¹⁸ per cubic centimeter.

14. Bipolar transistor according to one of Claims 10 to 13,
**characterized in that**
the lightly doped emitter (16) is designed as an essentially monocrystaline layer and is laterally bounded by (111) faces.

15. Bipolar transistor according to one of Claims 10 to 14,
**characterized in that**
the sidewall spacer (23) is designed as a nitride spacer.

16. The bipolar transistor according to one of Claims 10 to 15,
**characterized in that**
the base connection (25) is a highly doped, in particular a P+ doped, base connection.

17. The bipolar transistor according to one of Claims 10 to 16,
**characterized in that**
the collector (12) is in contact with a buried layer (11).

## Revendications

1. Procédé de fabrication d'un transistor bipolaire, notamment d'un transistor bipolaire npn, comprenant les stades :
a) on se procure un substrat semi-conducteur ayant un collecteur, une base et une couche d'émetteur dopée faiblement ;
b) on dépose un masque sur la couche d'émetteur dopée faiblement ;
c) à l'aide du masque on attaque en voie chimique humide la couche d'émetteur dopée faiblement de manière à former un émetteur dopé faiblement ;
d) on forme une borne de base sur les parties mises à nue de la base ;
e) on élimine le masque et on forme un émetteur dopé fortement.

2. Procédé suivant la revendication 1,
**caractérisé en ce que**
on utilise comme base une base en germanium-silicium dopée fortement.

3. Procédé suivant la revendication 1 ou 2,
**caractérisé en ce que**
le masque comprend une couche d'oxyde, une couche de silicium et une couche de nitrure.

4. Procédé suivant l'une des revendications précédentes,
**caractérisé en ce que**
l'on attaque la couche d'émetteur dopée faiblement en voie chimique humide par un agent d'attaque alcalin, notamment par de la KOH, de la choline et/ou de l'éthylènediamine.

5. Procédé suivant l'une des revendications précédentes,
**caractérisé**
**en ce qu'**on forme la couche d'émetteur dopée faiblement sur la base sous la forme d'une couche sensiblement monocristalline et on arrête l'attaque en voie chimique humide sur des surfaces (111) dans cette couche sensiblement monocristalline.

6. Procédé suivant l'une des revendications précédentes,
**caractérisé**
**en ce qu'**avant l'attaque en voie chimique humide, on produit sur les parois latérales du masque un espaceur de paroi latérale, de préférence un espaceur en nitrure.

7. Procédé suivant l'une des revendications 1 à 5,
**caractérisé**
**en ce qu'**avant la formation de la borne de base, on produit sur les parois latérales du masque et de l'émetteur dopé faiblement un espaceur de paroi latérale, de préférence un espaceur en nitrure.

8. Procédé suivant l'une des revendications précédentes,
**caractérisé en ce que**
l'on forme la borne de base sur les parties mises à nue de la base au moyen d'une épitaxie sélective.

9. Procédé suivant l'une des revendications précédentes,
**caractérisé en ce que**
l'on produit un espaceur de paroi latérale, de préférence un espaceur en nitrure, sur les parois latérales d'une fenêtre d'émetteur, avant la formation de l'émetteur dopé fortement.

10. Transistor bipolaire, notamment transistor bipolaire npn, comprenant un substrat (10) semi-conducteur, un collecteur (12), une base (14), un émetteur (16) dopé faiblement et un émetteur (17) dopé fortement,
**caractérisé en ce que**
la partie monocristalline de la borne (25) de base est dirigée sensiblement parallèlement à l'émetteur (16) dopé faiblement, est séparée de l'émetteur (16) dopé faiblement par un espaceur (23) de paroi latérale par une jonction pn et est formée au moins par régions sur la base (14).

11. Transistor bipolaire suivant la revendication 10,
**caractérisé en ce que**
la base est une base en silicium-germanium dopée fortement.

12. Transistor bipolaire suivant la revendication 10 ou 11,
**caractérisé en ce que**
la base (14) a un dopage, notamment un dopage p⁺ de plus de 2 10¹⁹ par cm³.

13. Transistor bipolaire suivant l'une des revendications 10 à 12,
**caractérisé en ce que**
l'émetteur (16) dopé faiblement a un dopage, notamment un dopage n, de moins de 2 10¹⁸ par cm³.

14. Transistor bipolaire suivant l'une des revendications 10 à 13,
**caractérisé en ce que**
l'émetteur (16) dopé faiblement est sous la forme d'une couche sensiblement monocristalline et est délimitée latéralement par des surfaces (111).

15. Transistor bipolaire suivant l'une des revendications 10 à 14,
**caractérisé en ce que**
l'espacer (23) de paroi latérale est sous la forme d'un espaceur en nitrure.

16. Transistor bipolaire suivant l'une des revendications 10 à 15,
**caractérisé en ce que**
la borne (25) de base est une borne de base dopée fortement, notamment dopée P⁺.

17. Transistor bipolaire suivant l'une des revendications 10 à 16,
**caractérisé en ce que**
le collecteur (12) est en contact avec une couche (11) enterrée.
